Europäisches Patentamt

European Patent Office

Office européen des brevets

(11) Publication number: **0 257 948**
**A2**

# (12) EUROPEAN PATENT APPLICATION

(21) Application number: 87307236.7

(22) Date of filing: 17.08.87

(51) Int. Cl.4: **H 01 L 23/48**

(30) Priority: 25.08.86 US 900034

(43) Date of publication of application:
02.03.88 Bulletin 88/09

(84) Designated Contracting States: **DE FR GB IT NL**

(71) Applicant: **AMERICAN TELEPHONE AND TELEGRAPH COMPANY**
**550 Madison Avenue**
**New York, NY 10022 (US)**

(72) Inventor: **Levy, Roland Albert**
**40 Summit Road**
**Murray Hill New Jersey 07974 (US)**

(74) Representative: **Johnston, Kenneth Graham et al**
**Western Electric Company Limited 5 Mornington Road**
**Woodford Green Essex, IG8 OTU (GB)**

(54) Conductive via plug for CMOS devices.

(57) A material such as boron nitride is conformally deposited and then patterned to form adherent portions (22) on the sidewalls of high-aspect-ratio vias (18) formed in a dielectric layer (16) of a CMOS device. A conductive material such as tungsten is then selectively deposited in the vias on the boron nitride and on silicon or silicide at the via bottoms. In some cases, the deposition of tungsten is controlled to fill the vias thereby leaving an advantageous substantially planar surface for subsequent metallization.

*FIG. 3*

**Description**

CONDUCTIVE VIA PLUG FOR CMOS DEVICES

Background of the Invention

This invention relates to microminiature solid-state devices and, more particularly, to very-large-scale-integrated (VLSI) devices of the complementary-metal-oxide-semiconductor (CMOS) type.

Conductive films are widely utilized in the fabrication of VLSI devices. In typical VLSI fabrication sequences, a conductive film is deposited on the top surface of a dielectric layer and in micron-or-submicron-size contact vias or holes formed in the dielectric layer.

In many cases of practical importance, the aforementioned contact vias exhibit very steep (near-vertical) sidewalls and high aspect or height-to-width ratios. Establishing a continuous and uniform conductive film on the dielectric layer and on the walls and bottom of each via therein is a challenging requirement. The edges and corners of deep steps are particularly difficult to cover reliably.

Conductive films made, for example, of a standard aluminum alloy (such as aluminum/copper or aluminum/silicon/copper) are typically deposited in a VLSI fabrication sequence by conventional line-of-sight sputtering or evaporation techniques. For high-aspect-ratio vias, these techniques frequently provide inadequate step coverage, which may result in the formation of microcracks and discontinuities in the current-carrying conductive film deposited in the vias. The possibility of such occurrences obviously poses a significant threat to the fabrication yield and reliability of VLSI devices.

For n-channel metal-oxide-semiconductor (NMOS) devices, the aforementioned step-coverage problem relative to contact vias can usually be overcome by the use of a so-called polysilicon plug. In accordance therewith, a film of polysilicon is deposited on the dielectric layer and in the vias formed therein. This is typically done in a low-pressure chemical-vapor-deposition step in which polysilicon is conformally deposited and then doped to render it conductive. An aluminum alloy film is then deposited on top of the doped polysilicon. The aluminum alloy-over-polysilicon composite is then patterned in sequential dry etching steps.

In the polysilicon-plug process, any electrical discontinuities caused by poor step coverage of the deposited aluminum alloy are in effect bridged by the underlying conformally deposited film of conductive polysilicon. Relatively high fabrication yields and good reliability of NMOS devices having high-aspect-ratio vias are thereby ensured.

Unfortunately, the use of the aforementioned polysilicon-plug technique is not readily implementable for making CMOS devices. This is so because of the potential contamination of source/drain regions that might occur during single-step doping of the polysilicon film to render it conductive. Doping of the polysilicon film in two separate steps would involve extra lithography which in turn would complicate the overall fabrication procedure and potentially impact the device yield.

Accordingly, efforts have continued by workers skilled in the art directed at trying to achieve good contacts in high-aspect ratio vias included in VLSI devices. It was recognized that such efforts, if successful, had the potential for contributing significantly to the realization of reliable low-cost CMOS devices.

Summary of the Invention

Hence, an object of the present invention is to provide improved microminiature devices. More specifically, an object of this invention is to improve VLSI CMOS devices of the type that include high-aspect-ratio contact vias.

Briefly, these and other objects of the present invention are realized in a specific illustrative VLSI CMOS device in which high-aspect-ratio contact vias are formed in a dielectric layer. In accordance with the invention, a thin layer of a material such as boron nitride is first uniformly deposited on the dielectric layer and on the walls and bottoms of the vias. This is done conformally in a chemical-vapor-deposition step. Then the deposited layer is anisotropically dry etched. This results in removal of the boron nitride from the top surface of the dielectric layer and from the bottoms of the vias. The only remaining boron nitride comprises relatively thin portions on the walls of the vias.

A metal such as tungsten is then selectively deposited in a conformal way on the device structure. In particular, tungsten forms on the boron nitride within the vias and on the material (typically silicon or metal silicide) that exists at the via bottoms. But no tungsten forms on the surface of the dielectic layer. Subsequently, a conductive material such as an aluminum alloy is deposited on the surface of the dielectric layer and on the tungsten in the vias.

Applicant's invention comprises a method of fabricating a semiconductor device of the type that includes a dielectric layer having at least one via formed therethrough, the supporting surface for the dielectric layer comprising a surface of a metal, metal silicide or silicon at the bottom of each via. More specifically, the method comprises the step of conformally depositing a uniform adherent layer on the top surface of the dielectric layer and on the sidewall and bottom of each via, the method being characterized by the steps of anisotropically etching the adherent layer to leave portions thereof on the sidewall of each via, conformally depositing a conductive material only on the sidewall portion and on the surface at the bottom of each via to form a conductive plug therein, and forming a conductive pattern on the top surface of the dielectric layer and in contact with at least one of the conductive via plugs.

Applicant's invention further includes a semiconductor device that comprises a dielectric layer having at least one via formed therethrough, each via including a sidewall defined by a portion of the layer. The device further includes means supporting the dielectric layer. The device is characterized in that an adherent liner layer is in contact with the sidewall of each via and with a limited portion of the supporting means at the bottom of each via, and in that an electrically conductive material within the via is adherently attached to the liner layer and to the remaining portion of the supporting means at the bottom of each via.

## Brief Description of the Drawing

A complete understanding of the present invention and of the above and other objects and features thereof may be gained from a consideration of the following detailed description presented hereinbelow in connection with the accompanying drawing, not drawn to scale, in which:

FIG. 1 schematically depicts in idealized form a via-containing portion of a particular illustrative VLSI device to which the principles of the present invention are applicable;

FIG. 2 shows a uniform layer deposited on the FIG. 1 device;

FIG. 3 depicts the portions of the uniform layer that remain after anisotropic etching thereof;

FIG. 4 represents the FIG. 3 device after selective deposition of a conductive material;

and FIG. 5 illustrates a multilayered device that includes two vias filled in accordance with applicant's inventive principles.

## Detailed Description

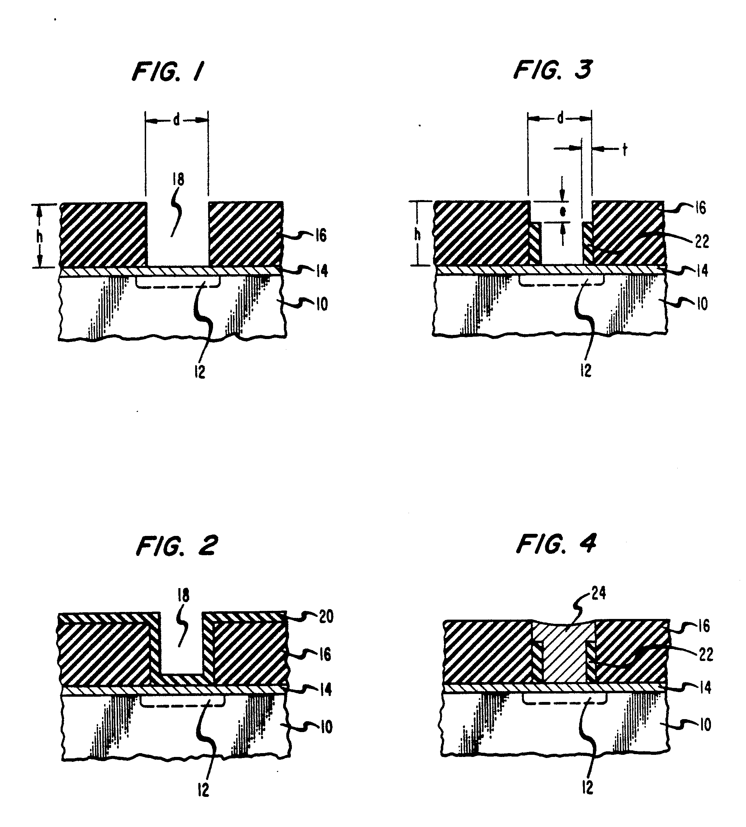

The illustrative device represented in FIG. 1 is a portion of a conventional CMOS device. The depicted device includes a silicon body 10 having a standard source/drain region 12 formed therein. Overlying the region 12 is a conventional metla silicide portion 14 which, for example comprises cobalt silicide. The portion 14 is designed to effect a good electrical connection to the region 12.

The device of FIG. 1 also includes a dielectric layer 16 made, for example, of a glass material such as phosphosilicate glass or borophosphosilicate glass. By standard techniques, a contact via 18 is formed in the layer 16. Electrical connection to the source/drain region 12 is established by depositing a suitable conductive material in the via 18 in contact with the silicide portion 14, as is well known in the art.

For illustrative purposes, the vertically walled contact via 18 of FIG. 1 will be assumed herein to have a height $h$ of about one micrometers ($\mu$m) and a diameter $d$ of approximately 0.5 $\mu$m. Such a via is considered to have a relatively high aspect ratio. In practice, it is extremely difficult to achieve good step coverage in such a via and to establish reliable electrical contact between a conductive material deposited in the via 18 and that part of the underlying portion 14 that is exposed at the bottom of the via.

In accordance with the principles of the present invention, a relatively thin and uniform layer of a nonconductive material is adherently deposited in a conformal manner on all the exposed surfaces of the device represented in FIG. 1. Such a layer 20 is shown in FIG. 2.

Illustratively, the layer 20 comprises a chemical-vapor-deposited (CVD) layer of boron nitride about 1000-to-2000 Angstrom units (Å) thick. (For purposes of an illustrative example, the thickness of the particular layer 20 specified below will be assumed to be about 1000 Å). In practice, such a layer has been determined to adhere conformally to the top and side surfaces of the dielectric layer 16 and to that part of the silicide portion 14 that is exposed at the bottom of the via 18 Such a deposited layer 20 exhibits excellent step coverage of high-aspect-ratio vias having vertical or near-vertical walls.

By way of a specific illustrative example, the layer 20 of FIG. 2 is formed by deposition in a conventional low-pressure (LP) CVD reactor utilizing dilute $B_2H_6$ (15 volume percent in $N_2$) and $NH_3$ as source gases. Flow rates of these gases were controlled to yield approximately 50 sccm of dilute $B_2H_6$ and 50 sccm of $NH_3$ thus establishing $NH_3/B_2H_6$ ratio of about 7:1. The deposition temperature was set at about 375 degrees Celsius while the total pressure within the reactor was maintained at approximately 0.2 torr. Under these conditions, a boron nitride layer with a stoichiometry of $B_3NH$ was deposited at a rate of approximately 30 Å per minute. The layer so deposited exhibited a relatively low defect density (for example, only about 0.1 per square centimeter).

Next, in accordance with the principles of applicant's invention, the layer 20 of FIG. 1 is anisotropically etched. Illustratively, the layer 20 is dry etched in a reactive-ion-etching step. Etching is carried out to remove at least those portions of the layer 20 on the top surfaces of the dielectric layer 16 and those portions of the layer 20 at the bottoms of vias. In this case, the remaining portions of the layer 20 constitute sidewall liners each having a height $h$ in the respective vias formed in the dielectric layer 16.

Advantageously, for a reason that will be evident later below, the layer 20 is purposely overetched. By following the particular procedure specified below, overetching can be accomplished with no apparent erosion of the surface of the silicide portion 14. After such an overetching step, sidewall liner 22 in the via 18 appears as shown in FIG. 3. In one particular illustrative case in which the height $h$ of the via 18 is one $\mu$m, the layer 20 was overetched such that the top surface of the sidewall liner 22 was approximately 0.15 $\mu$m below the top surface of the dielectric layer 16. The distance between these surfaces is designated $e$ in FIG. 3.

Illustratively, anisotropic etching of the boron nitride layer 20 was carried out in a reactive-ion-etching mode in a standard parallel-plate reactor employing $CF_4/4\%$ $O_2$ as the gas from which the etching plasma was derived. The operating power was set at approximately 450 watts. The total pressure within the reactor was established at about 3 millitorr. Under these conditions, an etch rare for boron nitride of aprroximately 90 Å per minute was achieved and negligible etching of the silicide portion 14 (FIG. 3) was observed.

Subsequently, in accordance with the principles of the present invention, a conductiver material such as tungsten is selectively deposited only on the top and side surfaces of the 1000-Å-thick boron nitride liner 22 (FIG. 3) and on the exposed part of the top surface of the silicide portion 14. Significantly, no tungsten adheres to exposed surfaces of the dielectric layer 16.

By depositing a layer of tungsten at least about 0.15 μm thick, the 0.5-μm-diameter via 18 containing the liner 22 (FIG. 3) is approximately completely filled. Moreover, the top of the tungsten-filled via is approximately co-planar with the top surface of the dielectric layer 16. In FIG. 4, reference numeral 24 designates the deposited tungsten plug, which is shown as having a slightly concave top-surface topography.

Illustratively, tungsten was deposited to form the conductive via plug 24 shown in FIG. 4 in a conventional LPCVD reactor. By way of example, this was done by utilizing $H_2$ reduction of $WF_6$, as is well known in the art. Flow rates of the $H_2$ and $WF_6$ gases were set, for example, at about 4000 sccm and 10 sccm, respectively. The temperature of deposition was established at approximately 350 degrees Celsius, and the total operating pressure within the reactor was set at about one torr. Under these conditions, adherent tungsten was formed only on the boron nitride liner 22 and on the silicide portion 14 at a rate of approximately 10 Å per minute.

Tungsten deposition temperatures less than about 350 degress Celsius are generally undesirable because they tend to result in relatively poor adhesion of tungsten to boron nitride. Also, temperatures more than about 350 degrees Celsius are also generally undesirable because they tend to cause increased risk of losing deposition selectivity with respect to exposed dielectric surfaces.

A specific illustrative sequence of steps utilized to deposit tungsten in the manner specified herein included a preclean in a 100:1 hydrofluoric acid solution for 2 minutes followed by a 10-minute water rinse and a 2-minute drying cycle. Subsequently, the devices were introduced into the LPCVD reactor which was then pumped down to about 0.2 torr. Next , $H_2$ was introduced at a flow rate of 4000 sccm and $WF_6$ was added at a rate of 10 sccm. At the end of the deposition cycle, the $WF_6$ flow was interrupted followed by interruption of the $H_2$ flow. The reactor was then brought up to atmospheric pressure by introducing $N_2$ gas therein.

A substantially planar such as the slightly concave top surface of the conductive via plug 24 shown in FIG. 4 facilitates later device fabrication steps. Such a surface is an advantageous one for, for example, subsequent deposition and patterning of aluminum. No aluminum underlayer is present in this case to complicate the metallization patterning.

As indicated in FIG. 4, a relatively small-area portion of the material deposited in the via in contact with the silicide portion 14 comprises the aforedescribed boron nitride sidewall liner 22. The liner 22 is nonconductive. Nevertheless, the quality of the contact that is achieved in practice in the depicted via between the relatively large-area conductive tungsten plug 24 and the silicide portion 14 has been determined to be adequate for fabricating high-quality VLSI CMOS devices.

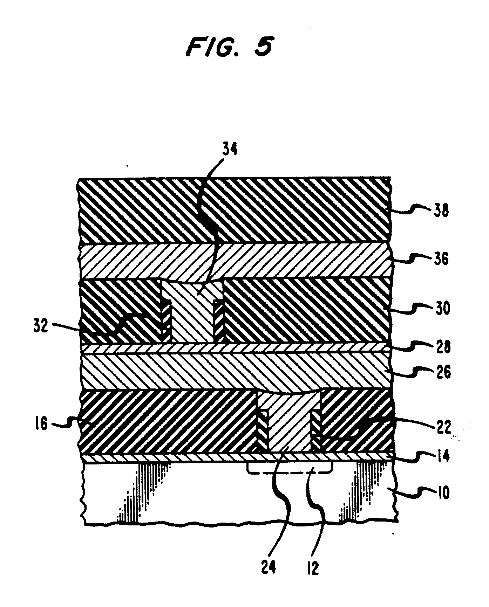

FIG. 5 shows a layer 26 made, for example, of a standard aluminum alloy deposited on the substantially planar surface defined by the dielectric layer 16 and the aforedescribed conductive via plug 24. Illustratively, such a layer 26 comprises one level of a multilevel metallization structure. In such a structure, additional via plugs made in accordance with the principles of the present invention may be utilized to interconnect spaced-apart conductive layers.

Accordingly, by way of example, FIG. 5 shows a layer 28 made of a suitable metal such as cobalt or a metal silicide such as cobalt silicide deposited on top of the conductive layer 26. (The layer 28 will serve as a basis for subsequent selective deposition of tungsten.) Further, another dielectric layer 30 having a via therethrough is formed overlying the layer 28. In turn, as shown in FIG. 5, this via filled with a boron nitride sidewall 32 and a conductive tungsten plug 34 both of which are advantageously formed in the particular illustrative manner specified earlier above. Subsequently, another layer 36 of a standard aluminum alloy is deposited and patterned overlying the dielectric layer 30. Lastly, a standard encapsulating layer 38 made, for example, of a material such as silicon nitride is deposited on top of the layer 36.

Thus, there has been described herein an advantageous way of conductively filling high-aspect-ratio vias in microminiature devices. The conductive via plugs thereby achieved are characterized by excellent step coverage, good adherence and adequate conductance to satisfy practical device requirements. Moreover, the procedure for forming the plug is easily adaptable to achieve substantially planar filling of vias.

Finally, it is to be understood that the above-described arrangement and techniques are only illustrative of the principles of the present invention. In accordance with these principles, numerous modifications and alternatives may be devised by those skilled in the art without departing from the spirit and scope of the invention. For example, although the primary emphasis herein has been directed to sidewall liners made of boron nitride, it is to be understood that other materials such as LPCVD boron, LPCVD titanium nitride or plasma-enhanced CVD silicon nitride are suitable for forming such liners in high-aspect-ratio vias. Silicon nitride liners can, for example, be conformally deposited in vias in a step utilizing silane and ammonia as source gases. Additionally, metals other than cobtalt and metal silicides other than cobalt silicide can be employed to form the layers 14 and 28 described above. Further more, in some cases of practical interest, the layer 14 can be omitted altogether. In those cases, tungsten or a suitable alternative such as molybdenum is selectively deposited in an adherent manner directly on those portions of the top surface of the silicon body 10 that are exposed at the bottoms of the vias to be filled.

Still further, in accordance with the principles of the present invention, the aforespecified sidewall liner may be made of LPCVD polysilicon. As described above, such a liner may be formed by a conformal deposition followed by anisotropic etching. Subsequently, the liner is either partially or completely transformed into a conductive silicide layer by reaction with a selectively deposited metal. Such a selective deposition is achieved in an LPCVD step in which metal is formed only on surfaces of the liner and on surfaces at via bottoms. Suitable metals deposited by such a process include, for example, titanium, tungsten, molybdenum, tantalum, etc.

The above-specified transformation of the liner into a silicide may occur during the metal-deposition step itself (such as in the case of titanium typically deposited at about 800 degrees Celsius) or in a post-deposition annealing step (such as in the case of tungsten where deposition typically is carried out at about 300 degrees Celsius and the silicide forms at approximately 650 degrees Celsius).

Also, even though, as described above, it is often advantageous to achieve a substantially planar filling of vias with conductive plugs, applicant's invention is of course not limited thereto. In those cases in which the conductive plug does not fill the via, the conductive material (for example, the aluminum alloy) deposited thereover may not form a continuous conformal layer in the via. But, significantly, any electrical discontinuities of such deposited material are in effect bridged by the underlying conformally deposited plug.

**Claims**

1. A semiconductor device comprising a dielectric layer (16) having at least one via (18) formed therethrough, each via (18) including a sidewall defined by a portion of said layer (16), and means (10,14) supporting said dielectrical layer (16), CHARACTERISED IN THAT an adherent liner layer (22) is in contact with the sidewall of each via (18) and with a limited portionof the supporting means at the bottom of each via (18), and an electrically conductive material (24) within said via (18) is adherently attached to said liner layer (22) and to the remaining portion of the supporting means at the bottom of each via (18).

2. A device as in claim 1 CHARACTERISED IN THAT said device comprises a CMOS device and said at least one via (18) is characterised by a high aspect ratio.

3. A device as in claim 2, CHARACTERISED IN THAT said liner layer (22) comprises conformally deposited boron nitride.

4. A device as in claim 3, CHARACTERISED IN THAT said conductive material (24) comprises conformally deposited tungsten.

5. A device as in claim 4, CHARACTERISED IN THAT said limited portion comprises a metal silicide.

6. A device as in claim 5, CHARACTERISED IN THAT said metal silicide comprises cobalt silicide.

7. A device as in claim 4, CHARACTERISED IN THAT said limited portion comprises silicon.

8. A device as in claim 6, CHARACTERISED IN THAT said dielectric layer (16) comprises a glass material.

9. A device as in claim 8, CHARACTERISED IN THAT the top surface of said liner layer (22) within each via (18) is below the top surface of said dielectric layer (16).

10. A device as in claim 9, CHARACTERISED IN THAT the top surface of said conductive material (24) is substantially coplanar with the top surface of said dielectric layer (16).

11. A device as in claim 10 further CHARACTERISED BY a patterned conductive layer (26) deposited on said top surfaces.

12. A device as in claim 11, CHARACTERISED IN THAT said patterned conductive layer (26) comprises aluminum.

13. A device as in claim 12, further CHARACTERISED BY a metal silicide layer (28) on said patterned conductive layer (26).

14. A device as in claim 13 still further CHARACTERISED BY a dielectric layer (30) on said patterned conductive layer (26), said dielectric layer (30) having at least one via formed therethrough, each via including a sidewall defined by a portion of said second-mentioned dielectric layer (30), an adherent liner layer (32) in contact with the sidewall of each via in said second-mentioned dielectric layer (30) and in contact with a limited portion of the silicide layer (28) at the bottom of each such via, and an electrically conductive material (34) within each via in said second-mentioned dielectric layer (30) and adhered to the liner layer (32) therein and to the remaining portion of the silicide layer (28) at the bottom of each such via.

15. A method of fabricating a semiconductor device of the type that includes a dielectric layer (16) having at least one via (18) formed therethrough, the supporting surface for said dielectric layer (16) comprising a surface of a metal, metal silicide or silicon at the bottom of each via (18), said method comprising the step of conformally depositing a uniform adherent layer (20) on the top surface of said dielectric layer (16) and on the sidewall and bottom of each via (18), said method being CHARACTERISED BY the steps of anisotropically etching said adherent layer (20) to leave portions thereof only on the sidewall of each via (18), conformally depositing a conductive material (24) only on said sidewall portion and on the surface at the bottom of each via to form a conductive plug therein, and forming a conductive pattern (26) on the top surface of said dielectric layer (16) and in contact with at least one of said conductive via plugs.

16. A method as in claim 15, CHARACTERISED IN THAT said uniform adherent layer (20) comprises boron nitride deposited in a CVD step.

17. A method as in claim 16, CHARACTERISED IN THAT said etching step comprises reactive ion etching said boron nitride layer in a

plasma derived from $CF_4$ and $0_2$.

18. A method as in claim 17, CHARACTERISED IN THAT said conductive material comprises tungsten deposited in a CVD step.

19. A method as in claim 18, CHARACTERISED IN THAT said conductive pattern (26) comprises aluminum.

20. A method as in claim 15, CHARACTERISED IN THAT said conductive material is formed by depositing a metal and either partially or completely reacting said metal with underlying material to form a silicide.

21. A method as in claim 20. CHARACTERISED IN THAT said silicide is formed during metal deposition.

22. A method as in claim 20 CHARACTERISED IN THAT said silicide is formed in a post-deposition annealing step.

0257948

FIG. 1

FIG. 3

FIG. 2

FIG. 4

0257948

FIG. 5